(19) **Europäisches Patentamt / European Patent Office / Office européen des brevets**

(11) **EP 1 540 825 B1**

(12) **EUROPEAN PATENT SPECIFICATION**

(45) Date of publication and mention
of the grant of the patent:
**02.07.2008 Bulletin 2008/27**

(51) Int Cl.:
*H03M 1/66* (2006.01)  *H03M 1/06* (2006.01)

(21) Application number: **03749360.8**

(22) Date of filing: **03.09.2003**

(86) International application number:
**PCT/US2003/027521**

(87) International publication number:
**WO 2004/023660 (18.03.2004 Gazette 2004/12)**

(54) **HIGH-SPEED LOW-DISTORTION ANALOG-TO-DIGITAL CONVERTER**

SCHNELLE ANALOG/DIGITAL-UMSETZER MIT NIEDRIGEN VERZERRUNGEN

CONVERTISSEUR ANALOGIQUE-NUMERIQUE A GRANDE VITESSE ET A FAIBLE DISTORSION

(84) Designated Contracting States:
**DE FR GB**

(30) Priority: **03.09.2002 US 407312 P**
**03.09.2002 US 645924**

(43) Date of publication of application:
**15.06.2005 Bulletin 2005/24**

(73) Proprietor: **Broadcom Corporation**
**Irvine, CA 92617 (US)**

(72) Inventors:
• **JIANG, Xicheng**
**Irvine, CA 92612 (US)**
• **WANG, Zhengyu**
**Los Angeles, CA 90066 (US)**
• **CHANG, Frank**
**Los Angeles, CA 90077 (US)**

(74) Representative: **Jehle, Volker Armin**
**Patentanwälte**
**Bosch, Graf von Stosch, Jehle,**
**Flüggenstrasse 13**
**80639 München (DE)**

(56) References cited:
US-A- 4 229 729   US-A- 5 157 397
US-B1- 6 169 510   US-B1- 6 246 258
US-B2- 6 369 743

• XICHENG JIANG ET AL: "A 2Gs/s 6b ADC in 0.18/spl mu/m CMOS" SOLID-STATE CIRCUITS CONFERENCE, 2003. DIGEST OF TECHNICAL PAPERS. ISSCC. 2003 IEEE INTERNATIONAL SAN FRANCISCO, CA, USA 9-13 FEB. 2003, PISCATAWAY, NJ, USA,IEEE, US, 9 February 2003 (2003-02-09), pages 1-10, XP010661507 ISBN: 0-7803-7707-9
• PATENT ABSTRACTS OF JAPAN vol. 2000, no. 07, 29 September 2000 (2000-09-29) & JP 2000 114895 A (HITACHI LTD; HITACHI ULSI SYSTEMS CO LTD), 21 April 2000 (2000-04-21)
• DERRICK CHUNKAI WEI ET AL: "A 300-MHz Fixed-Delay Tree Search-DFE Analog CMOS Disk-Drive Read Channel" IEEE JOURNAL OF SOLID-STATE CIRCUITS, IEEE SERVICE CENTER, PISCATAWAY, NJ, US, vol. 36, no. 11, November 2001 (2001-11), XP011061637 ISSN: 0018-9200

**Description**

BACKGROUND OF THE INVENTION

Field of the Invention

Applications such as disk drive read channels, fiber optical receivers, front end and data communication links using multi-level signaling (e.g. PAM and QAM) require high speed analog-to-digital converters (ADCs). It is of particular interest that such ADCs be fabricated in a standard CMOS technology. The main challenges in ADC performance are as follows: static and dynamic offset, low supply operation, design trade-offs between power, speed and chip area, time interleaving, gain-bandwidth optimization, highspeed input signal feed through and interpolation.

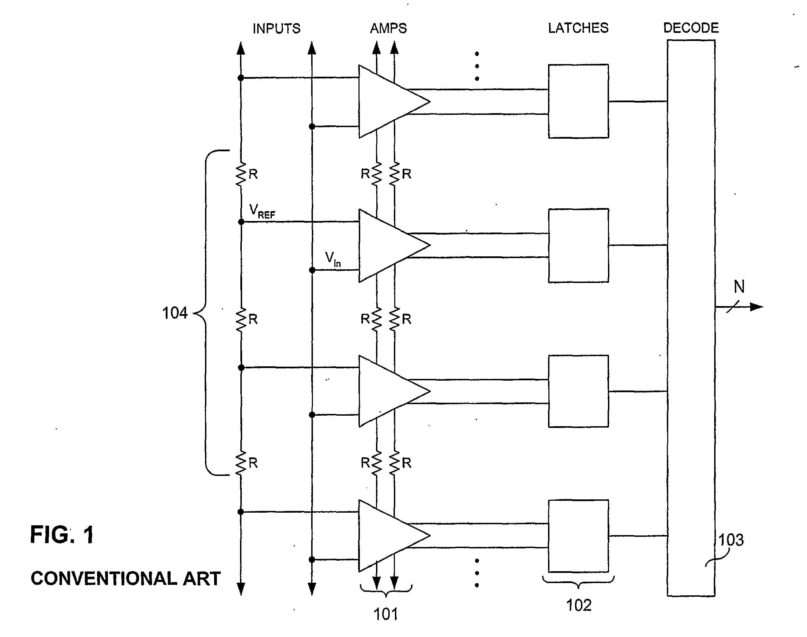

FIG. 1 shows a generic, conventional analog-to-digital converter. As shown in FIG. 1, the conventional analog-to-digital converter includes a resistor ladder 104 comprised of equal resistors R, an amplifier array 101, a corresponding array of latches 102, and a decode circuit 103.

The transistor performance in 0.18 $\mu$m CMOS process is ruled by threshold mismatch. Averaging, proposed by Kattman and Barrow, see "A Technique for Reducing Differential Nonlinearity Errors in Flash A/D Converters," ISSCC Digest of Technical Papers, pp. 170-171, Feb. 1991, is a proven technique to reduce offsets of the amplifiers array. *See also* K. Bult, A. Buchwald et al., "A 170 mW 10b 50 MSample/s CMOS ADC in 1 mm2," ISSCC Digest of Technical Papers, pp. 136-137, Feb.1997; H. Pan, et al., "A 12b 65 MSample/s CMOS ADC with 82dB SFDR at 120 MHz," ISSCC Digest of Technical Papers, pp. 38-39, Feb.2000; M. Choi, A.A. Abidi, "A 6b 1.3 GSample/s A/D Converter in 0.35 $\mu$m CMOS," ISSCC Digest of Technical Papers, pp. 126-127, Feb. 2001; and P. Scholtens and M. Vertregt, "A 6b 1.6 GSamples/s ADC in 0.18 $\mu$m CMOS Using Averaging Termination," ISSCC Digest of Technical Papers, pp. 168-169, Feb. 2002. However, an effective method to fix the boundary bending caused by offset averaging needs to be developed.

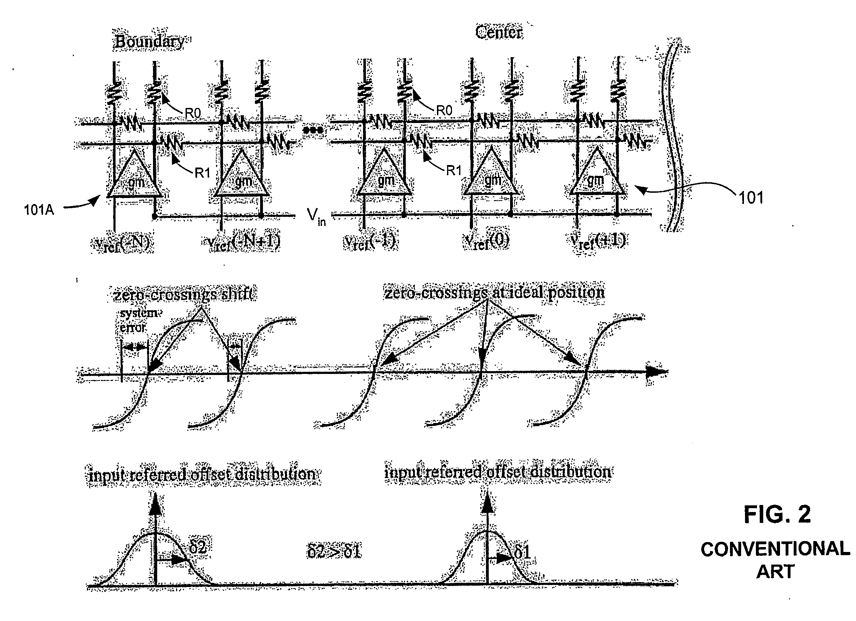

In general, there are two issues at the boundaries of the averaging network. First, the zero crossing points drift from the input reference voltage level due to the symmetrical nature is destroyed at the boundaries. This cause systematic non-linearity error. FIG. 2 illustrates zero-crossing shift versus amplifier position. Amplifier 101A is a "left edge" amplifier (see top portion of FIG. 2.) the zero crossings at the edges shift from their ideal values, causing distortion and nonlinearity. However, as may be seen from the middle portion of FIG. 2, the zero crossings in the center of the array 101 are located at the "ideal" position.

Additionally, the bottom portion of FIG. 2 shows another distorting edge effect, which is referred to as "offset distribution." As may be seen from the figure, the closer to the edge of the array 101 one gets, the greater the offset distribution, resulting in additional nonlinearity.

Thus, the downstream averaging network collects fewer random components for averaging at the boundaries. This causes less differential nonlinearity/integral nonlinearity (DNL/INL) improvement. State-of-the-art ADCs either use a partial of the amplifier array as dummies to preserve the electrical behavior of an infinite array of amplifiers (*see, e.g.*, K. Bult, A. Buchwald *et al.*, *supra* and H. Pan, *et al.*, *supra*), or use a termination method to suppress the zero-crossing shifts at the edge (*see* P. Scholtens and M. Vertregt, *supra*). The termination method can effectively restore the systematic error when $R_0 < 3R_1$, namely the averaging window is narrow and boundary issue is not serious. Yet the edges with termination have less averaging.

For the dummy approach (i.e., adding additional "dummy" amplifiers at the edges of array 101), the wider the averaging window, the more dummies are needed. For example, M. Choi, A.A. Abidi, indicate that 18 dummies are needed for an averaging window covering 18 amplifiers. Furthermore, the more dummy amplifiers that are added to the array 101, the greater the reduction in voltage headroom available for the analog-to-digital conversion, and the greater the power consumption of the ADC. For low voltage operation, this becomes unacceptable.

US 6,169,510 refers to A-D converters. The output of each cell in an A-D converter on an IC chip is dependent upon the relative values of an input voltage and an individual one of progressive fractions of a reference voltage respectively introduced to the branches in a differential amplifier. To minimize output errors from cell mismatches, first and second sets of averaging impedances, preferably resistors, are respectively connected between the output terminals in the first branches, and the output terminals in the second branches, in successive pairs of cells. The impedances have relatively low values, particularly compared to the impedances of current sources connected to the branch output terminals.

According to the invention, there is provided an analog to digital converter as defined by independent claim 1.

Further advantageous features of the invention are defined in the dependent subclaims.

Additional features and advantages of the invention will be set forth in the description that follows, and in part will be apparent from the description, or may be learned by practice of the invention. The advantages of the invention will be realized and attained by the structure particularly pointed out in the written description and claims hereof as well as the appended drawings.

It is to be understood that both the foregoing general description and the following detailed description are exemplary and explanatory and are intended to provide further explanation of the invention as claimed.

BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 illustrates a conventional analog-to-digital converter.
FIG. 2 is a graphic illustration of the problems inherent with the conventional analog-to-digital converter.
FIG. 3 illustrates an embodiment of the present invention using a triple cross connection.
FIG. 4A illustrates the problem of shifting of reference voltage values in a conventional voltage reference ladder.
FIG. 4B illustrates the use of programmable current sources to remedy reference voltage distortion.
FIG. 5 illustrates an alternative track and hold amplifier structure of the present invention.
FIG. 6 illustrates the nonlinearity performance when using the approaches of FIGs. 3 and 4A.
FIG. 7 illustrates dynamic performance using the track and hold amplifier of FIG. 5.
FIG. 8 illustrates the improvement and the edge effect when using the circuits illustrated in FIGs. 3 and 4B.
FIG. 9 illustrates dynamic performance of an ADC with the circuit of FIG. 5.
FIG. 10 illustrates overall system performance using the circuits shown in FIGs. 3, 4B and 5.

DETAILED DESCRIPTION OF THE INVENTION

Reference will now be made in detail to the embodiments of the present invention, examples of which are illustrated in the accompanying drawings.

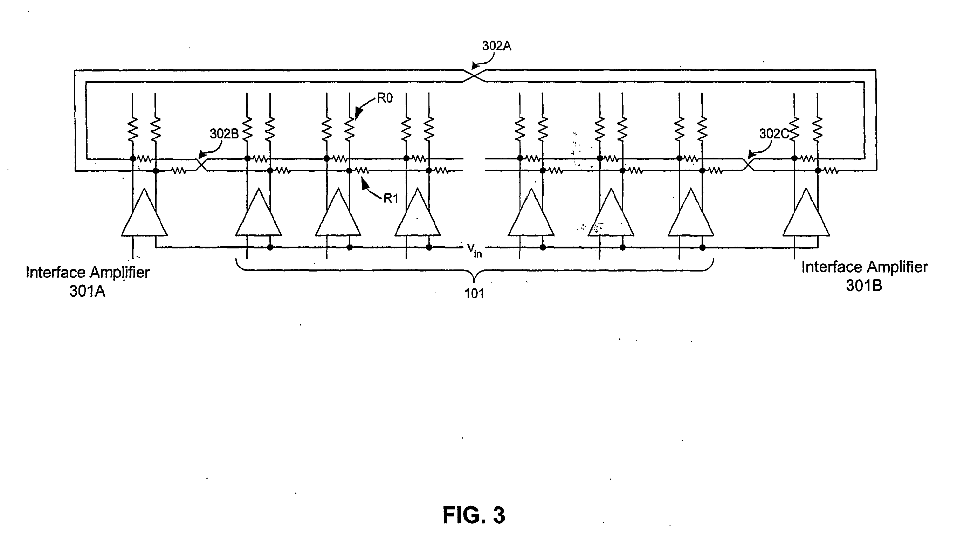

FIG. 3 illustrates an amplifier array of an analog-to-digital converter according to the present invention. As may be seen in FIG. 3, the amplifier array includes a plurality of amplifiers 101 (amplifier array 101), similar to FIG. 1. The outputs of the amplifier array 101 are fed to a resistor network comprising resistors R0 and R1, as shown in the figure (the latches and decoder of FIG. 1 are not shown for clarity). In addition to the amplifier array 101, on the edges of the amplifier array 101 there are two interface amplifiers 301A and 301B, as shown in the figure. The interface amplifiers 301A, 301B replace the dummy amplifiers of conventional analog-to-digital converter circuits. The interface amplifiers 301A, 301B are connected to the amplifier array 101 through two cross-points 302B, 302C, and to each other through a cross-point 302A, as shown in FIG. 3. This circuit allows the elimination of the dummy amplifiers on each edge of conventional amplifier arrays, dramatically reducing power consumption, and substantially solving the voltage headroom problem.

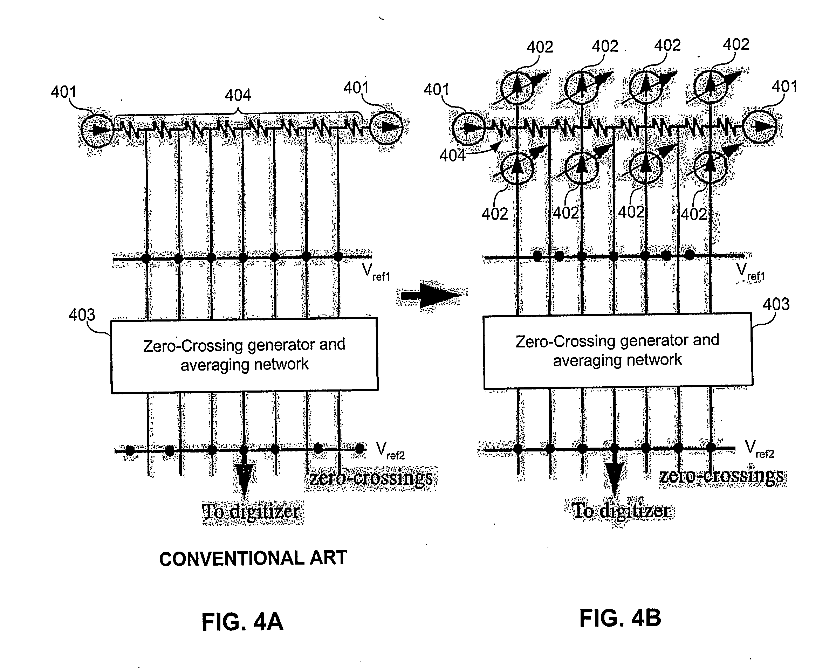

FIG. 4A illustrates the problem of reference voltage shift from a reference ladder 404. As shown in FIG. 4A, conventional analog-to-digital converter circuits include a reference ladder 404, with two current sources 401 on each side of the reference ladder 404, and taps leading to a zero crossing generator and averaging network 403. (Note that the "dots" at the $V_{REF1}$ and $V_{REF2}$ lines illustrate the shift in the zero crossing points that occurs due to the edge effect, as described above, and not two wires being connected together). As shown in FIG. 4A, and as discussed above with reference to FIG. 2, the zero crossing point shifts further and further from its ideal position as one gets closer to the edge of the amplifier array 101.

As an alternative, reference voltages can be pre-distorted to compensate for the zero-crossing shifts at the array boundary. The reference voltage is usually generated by a constant current flow through a resistor ladder 404. Since it is difficult to change the resistor values, the current flowing through resistor taps can be programmed instead, as shown in FIG. 4B.

FIG. 4B illustrates a solution to the problem of reference voltage shifts. As may be seen from FIG. 4B, in addition to the constant current sources 401, each tap from the reference ladder 404 includes two programmable current sources 402. Thus, through the use of programmable current sources 402, the reference ladder taps at the $V_{REF1}$ can be shifted back to their ideal positions at $V_{REF2}$. In other words, $V_{REF1}$ is predistorted to shift $V_{REF2}$ to its ideal position. Programmable current sources are well known in the art, and any number of circuits may be used. Furthermore, the programmable current sources 402 can be controlled through the use of relatively simple control logic, and may be reprogrammed "on the fly." Thus, through the use of programmable current sources 402, there is no longer a need for expensive trimming of resistors in the reference ladder 404, particularly since it is not so much the absolute values of the resistors that matter, but their values relative to each other.

The triple cross-connection averaging arrangement of FIG. 3, and the use of pre-distortion of the reference voltages (FIG. 4B) can maintain even averaging for a wide averaging window. The later method helps to relax the strict requirement of interface amplifiers 301A, 301B in the triple cross-connection averaging scheme of FIG. 3. The translational symmetry for the impulse response is maintained through triple cross-connections 302A, 302B, 302C, forming a circular resistor network. The input linear region of the transconductance (interface) amplifiers 301A, 301B should be wide enough to cover one edge of the original amplifiers array 101. The transconductance (interface) amplifiers 301A, 301B should satisfy:

$$g_{m,\,int}^{2} \bullet h^{2}(1) \bullet \frac{1}{W_{int}L_{int}} = \sum_{n=-N}^{-1} g_{m}^{2}(n) \bullet h^{2}(n) \bullet \frac{1}{WL},$$

where $g_{m,int}$, $W_{int}$ and $L_{int}$ are the transconductance, transistor width and length of the interface amplifier 301, $g_m$, W and L correspond to original amplifier array 101, and h(n) is the impulse response of the post-amplifier resistor network (comprised of R0, R1, see FIG. 3). This ensures a good integral non-linearity/differential non-linearity (INL/DNL) enhancement in the full range.

For the reference voltages, biasing currents for the interface amplifiers 301A, 301B are determined such that output zero-crossings of amplifier array 101 are as even as possible. The remaining nonlinearity can be remedied by a digitally controlled reference voltage of FIG. 4B. The reference voltages are traditionally tapped from a resistor ladder 404. The subtractors use these reference voltages to generate zero-crossings for a digitizer to make decisions.

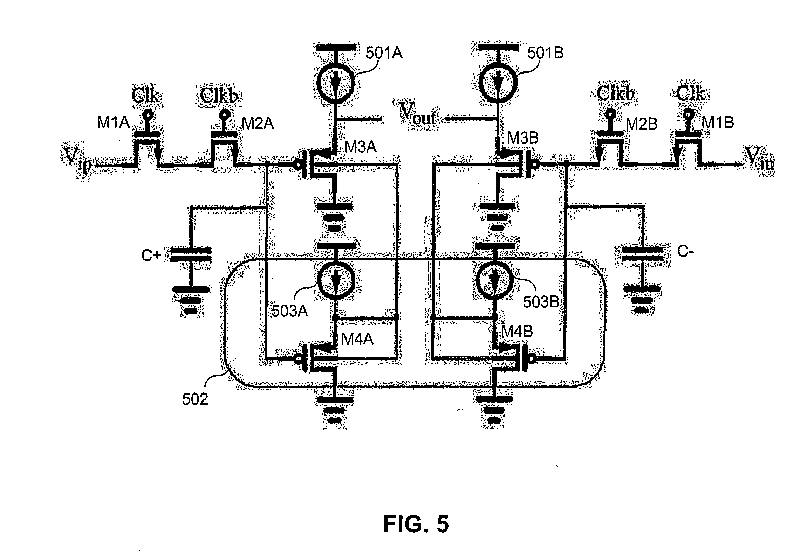

FIG. 5 illustrates an improved track and hold (T/H) amplifier that may be used in an analog-to-digital converter of the present invention. To enable the high speed and low supply operation, only open-loop and common mode logic (CML) type circuits are incorporated in this design. For Gigahertz sampling rate, using a T/H becomes essential to achieve the desired dynamic performance with a wide-band input signal.

As may be seen in FIG. 5, the track and hold amplifier includes two transistors M1A, M1B driven by the CLK input, two transistors M2A, M2B driven by the CLKB input, two current sources 501A, 501B connected to sources of transistors M3A, M3B, respectively, and two input capacitors C+, C- (which are typically about 0.5 pF).

The source follower's size (M3A, M3B) is quite large in order to drive the preamplifier bank 101 (array 101). The big non-linear well capacitance of M3A, M3B limits the T/H output bandwidth and adds distortion.

To address the distortion due to the wells of M3A, M3B, a replica circuit of a main source follower, designated 502, is added to the conventional track and hold amplifier. The replica circuit 502 includes two current sources 503A, 503B, and two transistors M4A, M4B biased by the current sources 503A, 503B. The addition of the replica circuit 502 provides bias to the wells of the transistors M3A, M3B, substantially reducing the nonlinearity effects that exist due to the bulk (substrate) connections of the transistors M3A, M3B. Replica circuit 502 tracks the source voltage of the main source follower and provides biasing to the wells of M3A, M3B. The replica circuit is about 5% of the main source follower size.

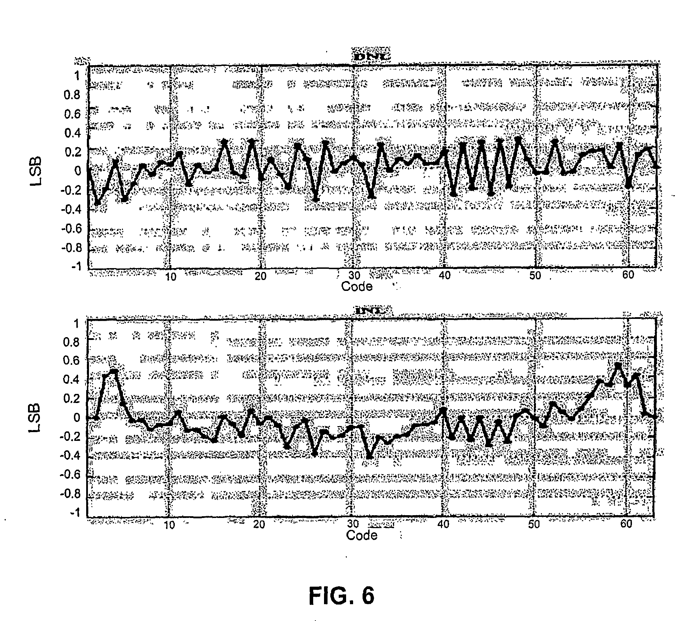

FIG. 6 illustrates the advantages of the embodiments shown in FIGs. 3 and 4B. As may be seen from the differential nonlinearity (DNL) graph of FIG. 6, the differential nonlinearity is under 0.3 LSB (least significant bit). Without the use of the circuits of FIGs. 3 and 4B, the DNL would be on the order of 5 LSB. Similarly, the integral nonlinearity (INL) is generally under 0.5 LSB, substantially lower than the numbers seen in conventional circuits. (The X axis represents to the digital codes, i.e., for a six-bit analog-to-digital converter, there are 64 digital codes, or 0-63.) In other words, through the use of the circuits illustrated in FIGs. 3 and 4B, the nonlinearity is reduced by an order of magnitude.

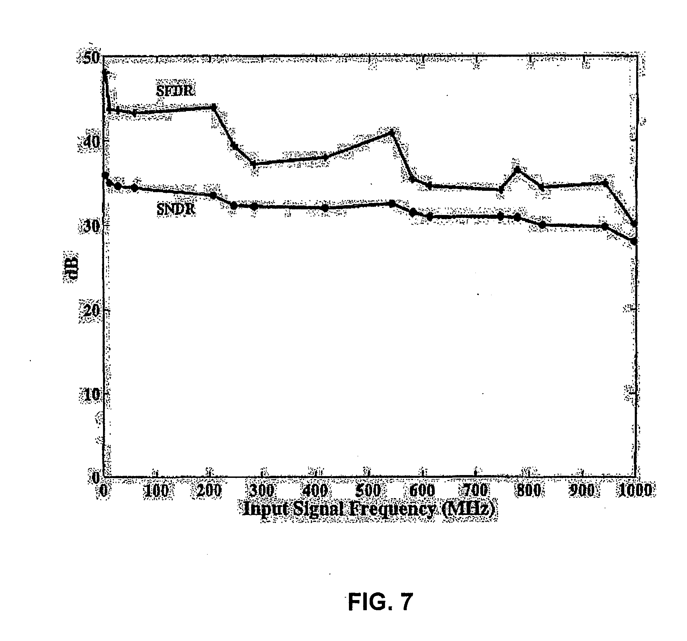

FIG. 7 illustrates dynamic performance achievable with the track and hold amplifier of FIG. 5. As may be seen from FIG. 7, the spurious free dynamic range (SFDR) and the signal-to-noise distortion ratio (SNDR) are extremely good all the way up to input frequencies of 1 GHz. Without the track and hold amplifier of FIG. 4, the performance would be about 15-20 dB worse than that shown in FIG. 7.

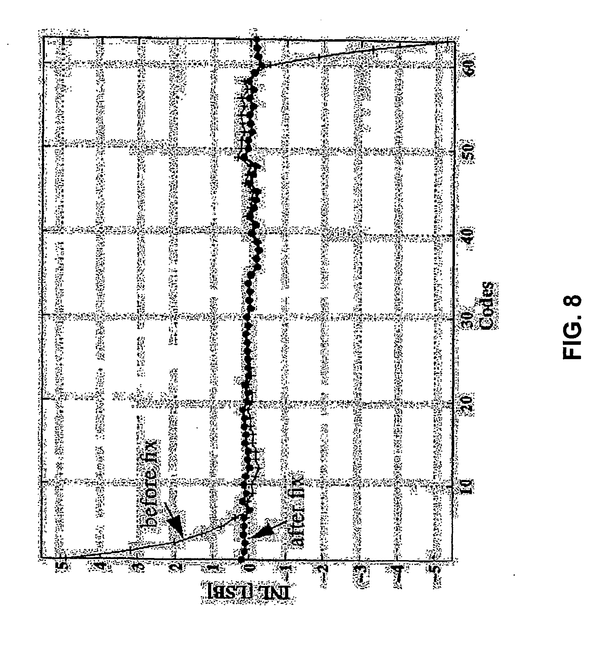

FIG. 8 shows the improvement in the integral nonlinearity (INL) at the edges of the amplifier array 101 using the circuits illustrated in FIGs. 3 and 4B. As may be seen in FIG. 8, while the performance is only somewhat better in the center of the array (i.e., digital codes ranging from about 7 to about 60), there is a dramatic improvement at the edges, i.e., codes 61-63 and codes 0-6.

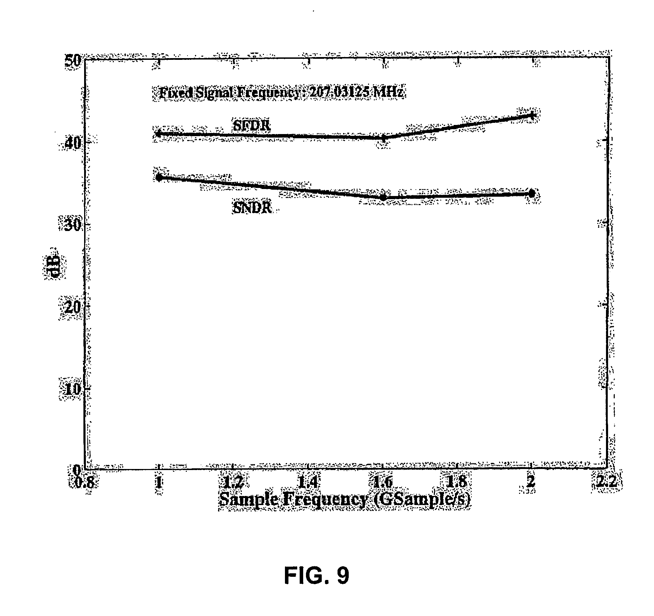

FIG. 9 illustrates the dynamic performance of an analog-to-digital converter using the track and hold amplifier of FIG. 5. As may be seen from FIG. 9, which shows SFDR and SNDR as a function of sampling frequency $f_s$, the dynamic performance is dramatically better, by about 15-20 dB, all the way up to approximately 2 Giga-samples per second.

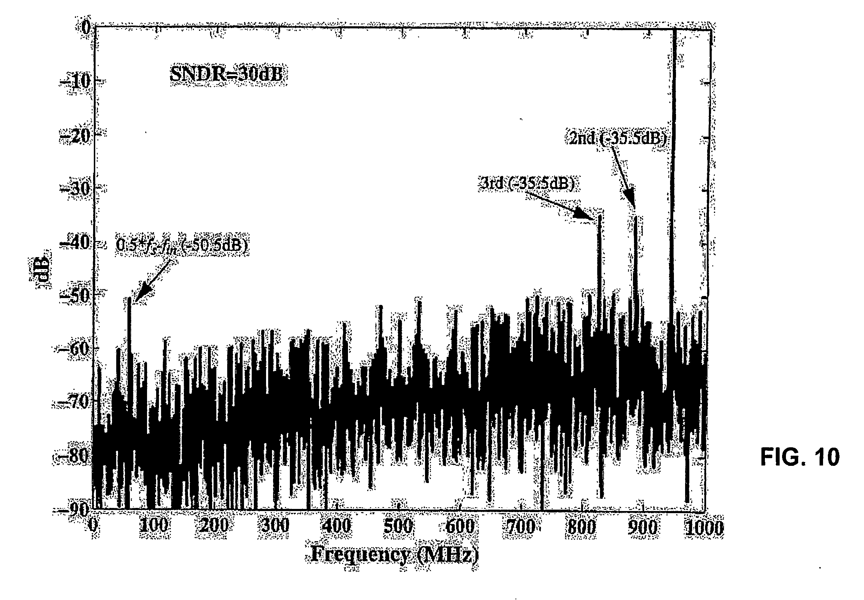

FIG. 10 illustrates overall system performance using the track and hold amplifier of FIG. 5, together with the interface amplifiers of FIG. 3 and the controllable current sources 402 of FIG. 4B. As may be seen in FIG. 10, the overall system performance is extremely good all the way to signal frequencies of close to 1 GHz.

The simulated INL profiles of the amplifier array 101 reduce peak INL from 5 LSB before fixing boundary problem to 0.3 LSB after fixing it. Three hundred times Monte-Carlo simulations show sigmas of the input referred offset at the array center and array edge are 1.37 mV and 1.41 mV respectively, which implies even averaging is achieved with the method of triple cross-connections and pre-distorting reference voltage.

Time-interleaving technology is often used to reduce the bandwidth requirements on individual amplifiers (except the front-end track and hold (T/H) still need full tracking bandwidth), and increases the data throughput with lower speed clocking. One advantage is that it can also save the power consumption in the system. The required gain to suppress the dynamic offset from the amplifier array is evenly distributed between preamplifier stages in a multi-stage ADC to maximize the bandwidth.

Fabricated in a 0.18 $\mu$m 1P6M CMOS technology, the prototype ADC occupies an active area of 0.5 mm$^2$. A clock amplifier and high speed digital buffers are integrated. A 50-Ohm on-chip termination for a 0.8 Volt differential clock helps to reduce the reflection. CMOS level data and clock directly drive Agilent logic analyzer 16702B, which has 1 GHz state mode and 4 GHz timing mode.

Instead of being mounted in a conventional package, the prototype of A/D converter was mounted on a printed circuit board with chip-on-board technology. Including front-end T/H and clock buffers, the circuits consume 310 mW from 1.8V at a 2-GHz conversion rate and 996 MHz input. The measured linearities are shown in FIG. 6. The peak DNL and INL are 0.32 LSB and 0.5 LSB respectively. FIG. 7 shows the measured SNDR and SFDR as function of input signal frequency. The effective resolution bandwidth reaches 1 GHz. This ADC achieves a state-of-the-art Figure-of-Merit of 3.5 pJ defined by ($Power$)/$2^{ENOB} \cdot 2 \cdot ERBW$), where ENOB is effective number of bits, and ERBW is effective resolution bandwidth.

It will be understood by those skilled in the art that various changes in form and details may be made therein without departing from the scope of the invention as defined in the appended claims. Thus, the breadth and scope of the present invention should not be limited by any of the above-described exemplary embodiments, but should be defined only in accordance with the following claims and their equivalents.

## Claims

1. An analog to digital converter comprising:

   an array of 1 to m differential input amplifiers, each inputting an input voltage and a corresponding voltage reference, and outputting a differential signal representing a comparison of the input voltage and the corresponding voltage reference;
   a resistor network connected at the outputs of the array of one to m differential input amplifiers;
   a plurality of latches storing the differential signal from each of the differential input amplifiers;
   a decoder converting the stored differential signals to N-bit digital output;

   **characterized in that** it further comprises a first and second interface amplifiers wherein the outputs of the first interface amplifier are cross-connected to the outputs of the first amplifier of the array of 1 to m differential input amplifiers, the outputs of the second interface amplifier are cross-connected to the outputs of the m-th amplifier of the array of 1 to m differential input amplifiers, and the outputs of the first interface amplifier are cross-connected to the outputs of the second interface amplifier.

2. The analog to digital converter of claim 1, wherein positive and negative outputs of each differential input amplifier of the array are connected to respective outputs of a neighboring differential input amplifier through corresponding resistors.

3. The analog to digital converter of claim 1, wherein positive and negative outputs of each interface amplifier are connected to respective outputs of the same polarity of a corresponding edge amplifier through corresponding resistors.

4. The analog to digital converter of claim 1, wherein a positive output of the first interface amplifier is connected to a negative output of the second interface amplifier through a first resistor.

5. The analog to digital converter of claim 4, wherein a negative output of the first interface amplifier is connected to a positive output of the second interface amplifier through a second resistor.

6. The analog to digital converter of claim 1, further including a track and hold amplifier inputting a differential input signal and outputting the input voltage to the array, the track and hold amplifier comprising: a first transistor pair driven by a clk signal at their gates; a second transistor pair driven by a clkb signal at their gates; a third transistor pair inputting the differential input signal at their gates through the first and second transistor pair, and having their sources biased by corresponding current sources ; and a replica circuit connected to the gates of the third transistor pair and to substrates of the third transistor pair for biasing wells of the third transistor pair so as to reduce nonlinear well behavior.

**Patentansprüche**

1. Analog-Digital-Umsetzer mit:

einer Reihe von 1 bis m Differenzeingangsverstärkern, von denen jeder eine Eingangsspannung und eine entsprechende Referenzspannung eingibt und ein Differenzsignal ausgibt, das einen Vergleich der Eingangsspannung mit der entsprechenden Referenzspannung repräsentiert;
einem Widerstands-Netzwerk, das an den Ausgängen der Reihe von einem bis m Differenzeingangsverstärkern angeschlossen ist;
einer Vielzahl von Signalspeichern, die das Differenzsignal von jedem der Differenzeingangsverstärker speichern;
einem Decodierer, der die gespeicherten Differenzsignale in eine N-Bit-Digitalausgabe umwandelt;

**dadurch gekennzeichnet, dass** er des Weiteren erste und zweite Schnittstellenverstärker umfasst, wobei die Ausgänge des ersten Schnittstellenverstärkers mit den Ausgängen des ersten Verstärkers der Reihe von 1 bis m Differenzeingangsverstärkern querverbunden sind, die Ausgänge des zweiten Schnittstellenverstärkers mit den Ausgängen des m-ten Verstärkers der Reihe von 1 bis m Differenzeingangsverstärkern querverbunden sind und die Ausgänge des ersten Schnittstellenverstärkers mit den Ausgängen des zweiten Schnittstellenverstärkers querverbunden sind.

2. Analog-Digital-Umsetzer nach Anspruch 1, wobei positive und negative Ausgänge jedes Differenzeingangsverstärkers der Reihe mit jeweiligen Ausgängen eines benachbarten Differenzeingangsverstärkers durch entsprechende Widerstände verbunden sind.

3. Analog-Digital-Umsetzer nach Anspruch 1, wobei positive und negative Ausgänge jedes Schnittstellenverstärkers mit jeweiligen Ausgängen der gleichen Polarität eines entsprechenden Kantenverstärkers durch entsprechende Widerstände verbunden sind.

4. Analog-Digital-Umsetzer nach Anspruch 1, wobei ein positiver Ausgang des ersten Schnittstellenverstärkers mit einem negativen Ausgang des zweiten Schnittstellenverstärkers durch einen ersten Widerstand verbunden ist.

5. Analog-Digital-Umsetzer nach Anspruch 4, wobei ein negativer Ausgang des ersten Schnittstellenverstärkers mit einem positiven Ausgang des zweiten Schnittstellenverstärkers durch einen zweiten Widerstand verbunden ist.

6. Analog-Digital-Umsetzer nach Anspruch 1, der des Weiteren einen Abtast-Halte-Verstärker enthält, der ein Differenzeingangssignal eingibt und die Eingangsspannung an die Reihe ausgibt, wobei der Abtast-Halte-Verstärker Folgendes umfasst: ein erstes Transistorpaar, das von einem clk-Signal an ihren Gates angesteuert wird; ein zweites Transistorpaar, das von einem clkb-Signal an ihren Gates angesteuert wird; ein drittes Transistorpaar, das das Differenzeingangssignal an ihren Gates durch das erste und zweite Transistorpaar eingibt und deren Sources von entsprechenden Stromquellen vorgespannt sind; und einen Replik-Schaltkreis, der mit den Gates des dritten Transistorpaars und mit Substraten des dritten Transistorpaars zum Vorspannen von Wannen des dritten Transistorpaars verbunden ist, um ein nichtlineares Wannenverhalten zu reduzieren.

**Revendications**

1. Convertisseur analogique-numérique comprenant :

un réseau de 1 à m amplificateurs d'entrée différentiels, chacun recevant en entrée une tension d'entrée et une référence de tension correspondante et délivrant en sortie un signal différentiel représentant une comparaison de la tension d'entrée et de la référence de tension correspondante ;
un réseau de résistances connecté aux sorties du réseau de 1 à m amplificateurs d'entrée différentiels ;
une pluralité de bascules stockant le signal différentiel provenant de chacun des amplificateurs d'entrée différentiels ;
un décodeur convertissant les signaux différentiels stockés en sortie numérique à N bits ;

**caractérisé en ce qu'**il comprend en outre un premier et un deuxième amplificateurs d'interface dans lesquels les sorties du premier amplificateur d'interface sont connectées en croix aux sorties du premier amplificateur du réseau de 1 à m amplificateurs d'entrée différentiels, les sorties du deuxième amplificateur d'interface sont connectées en croix aux sorties du m$^{ième}$ amplificateur du réseau de 1 à m amplificateurs d'entrée différentiels, et les sorties du premier amplificateur d'interface sont connectées en croix aux sorties du deuxième amplificateur d'interface.

2. Convertisseur analogique-numérique selon la revendication 1, dans lequel les sorties positive et négative de chaque amplificateur d'entrée différentiel du réseau sont connectées à des sorties respectives d'un amplificateur d'entrée différentiel voisin à travers des résistances correspondantes.

3. Convertisseur analogique-numérique selon la revendication 1, dans lequel les sorties positive et négative de chaque amplificateur d'interface sont connectées à des sorties respectives de la même polarité d'un amplificateur de bord correspondant à travers des résistances correspondantes.

4. Convertisseur analogique-numérique selon la revendication 1, dans lequel une sortie positive du premier amplificateur d'interface est connectée à une sortie négative du deuxième amplificateur d'interface à travers une première résistance.

5. Convertisseur analogique-numérique selon la revendication 4, dans lequel une sortie négative du premier amplificateur d'interface est connectée à une sortie positive du deuxième amplificateur d'interface à travers une deuxième résistance.

6. Convertisseur analogique-numérique selon la revendication 1, comprenant en outre un amplificateur de poursuite et maintien recevant en entrée un signal d'entrée différentiel et délivrant en sortie la tension d'entrée pour le réseau, l'amplificateur de poursuite et maintien comprenant : une première paire de transistors commandés par un signal clk sur leurs grilles ; une deuxième paire de transistors commandés par un signal clkb sur leurs grilles ; une troisième paire de transistors recevant en entrée le signal d'entrée différentiel sur leurs grilles à travers les première et deuxième paires de transistors, et ayant leurs sources polarisées par des sources de courant correspondantes ; et un circuit réplique connecté aux grilles de la troisième paire de transistor et à des substrats de la troisième paire de transistor pour polariser des puits de la troisième paire de transistor de manière à réduire un comportement de puits non linéaire.

**FIG. 1**

**CONVENTIONAL ART**

FIG. 2
CONVENTIONAL ART

**FIG. 3**

**CONVENTIONAL ART**

**FIG. 4A**

**FIG. 4B**

EP 1 540 825 B1

**FIG. 5**

EP 1 540 825 B1

FIG. 6

FIG. 7

EP 1 540 825 B1

FIG. 8

FIG. 9

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6169510 B

### Non-patent literature cited in the description

- **KATTMAN ; BARROW.** A Technique for Reducing Differential Nonlinearity Errors in Flash A/D Converters. *ISSCC Digest of Technical Papers,* February 1991, 170-171
- **K. BULT ; A. BUCHWALD et al.** A 170 mW 10b 50 MSample/s CMOS ADC in 1 mm. *ISSCC Digest of Technical Papers,* February 1997, 136-137
- **H. PAN et al.** A 12b 65 MSample/s CMOS ADC with 82dB SFDR at 120 MHz. *ISSCC Digest of Technical Papers,* February 2000, 38-39
- **M. CHOI ; A.A. ABIDI.** A 6b 1.3 GSample/s A/D Converter in 0.35 $\mu$m CMOS. *ISSCC Digest of Technical Papers,* February 2001, 126-127
- **P. SCHOLTENS ; M. VERTREGT.** A 6b 1.6 GSamples/s ADC in 0.18 $\mu$m CMOS Using Averaging Termination. *ISSCC Digest of Technical Papers,* February 2002, 168-169